# EUROPEAN PATENT SPECIFICATION

(11) **EP 0 331 094 B1**
(45) Date of publication and mention of the grant of the patent: **24.07.1996**
(21) Application number: 89103456.3
(22) Date of filing: 28.02.1989
(51) Int. Cl.: H03M 7/30, H04N 7/32

(54) **Multimedia data transmission system**
Übertragungssystem für Multimediadaten
Système de transmission de données multimédia

(30) Priority: 29.02.1988 JP 46391/88; 14.03.1988 JP 61415/88; 28.04.1988 JP 108145/88; 11.05.1988 JP 112602/88; 06.06.1988 JP 139655/88; 27.07.1988 JP 188801/88; 26.11.1988 JP 298724/88; 13.01.1989 JP 6801/89; 13.01.1989 JP 6807/89
(43) Date of publication of application: 06.09.1989
(60) Divisional application: 94107739.8
(73) Proprietor: MITSUBISHI DENKI KABUSHIKI KAISHA, Tokyo 100 (JP)
(72) Inventor: Murakami, Tokumichi c/o Mitsubishi Denki K.K., 1-1, Ofuna 5-chome Kamakura-shi Kanagawa (JP); Kamizawa, Koh c/o Mitsubishi Denki K.K., 1-1, Ofuna 5-chome Kamakura-shi Kanagawa (JP); Itoh, Atsushi c/o Mitsubishi Denki K.K., 1-1, Ofuna 5-chome Kamakura-shi Kanagawa (JP); Kato, Yoshiaki c/o Mitsubishi Denki K.K., 1-1, Ofuna 5-chome Kamakura-shi Kanagawa (JP); Hasegawa, Yuri c/o Mitsubishi Denki K.K., 1-1, Ofuna 5-chome Kamakura-shi Kanagawa (JP); Matsuzaki, Kazuhiro c/o Mitsubishi Denki K.K., 1-1, Ofuna 5-chome Kamakura-shi Kanagawa (JP); Fukuhara, Takahiro c/o Mitsubishi Denki K.K., 1-1, Ofuna 5-chome Kamakura-shi Kanagawa (JP)
(74) Representative: Eisenführ, Speiser & Partner

(56) References cited:
- EP-A- 0 288 963
- EP-A- 0 288 963
- US-A- 4 670 851
- IEEE GLOBAL TELECOMMUNICATIONS CONFERENCE & EXHIBITION, vol. 2/3, 28th November 1988, Hollywood, Florida, pages 1068-1072; T. MURAKAMI et al.: "Scene adaptive vector quantization for image coding"
- ICASSP '87 PROCEEDINGS, vol. 2/4, 6th April 1987, Dallas, US, pages 1059-1062; CHIA-LUNG YEH: "Color image-sequence compression using adaptive binary-tree vector quantization with codebook replenishment"
- ICASSP '85 PROCEEDINGS, vol. 1/4, 26th March 1985, Tampa, US, pages 133-136; A. GERSHO et al.: "Adaptive vector quantization by progressive codevector replacement"
- IEEE TRANSACTIONS ON COMMUNICATIONS, vol. 34, no. 7, July 1986, New York, US, pages 703-710; M. GOLDBERG et al.: "Image sequence coding using vector quantization"
- ICASSP '87 PROCEEDINGS, vol. 3/4, 6th April 1987, Dallas, US, pages 1378-1381; P.H. WESTERINK et al.: "Sub-band coding of image using predictive vector quantization"
- ICASSP '84 PROCEEDINGS, vol. 1/3, 19th March 1984, San Diego, US, pages 1071-1074; A.GERSHO et al.: "Full vector-quantized subband coding with adaptive codebook allocation"
- ICASSP '85 PRODCEEDINGS, vol. 1/4, 26th March 1985, Tampa, US, pages 125-127; N.M. NASRABADI: "Use of vector quantizers in image coding"
- ICASSP '88 PROCEEDINGS; MULTIDIMENSIONAL SIGNAL PROCESSING, vol. II, 11th March 1988, New York, US, pages 1324-1327; R.L. BAKER et al.: "A motion compensated vector quantizer"
- ELECTRONICS AND COMMUNICATIONS IN JAPAN, vol. 69, no. 3, March 1986, New York, US, pages 93-101; T. MUREAKAMI et al.: "Dynamic multistage vector quantization of images"
- ELECTRONICS AND COMMUNICATIONS IN JAPAN, vol. 69, no. 1, January 1986, New York, US, pages 75-84; T. UDA et al.: "Picture coding by an adaptive multistage vector quantization"
- ICASSP '86 PROCEEDINGS, vol. 1/4, 7th March 1986, Tokyo, Japan, pages 133-136; T. MURAKAMI et al.: "Vector quantization of color images"
- TENCON '87 PROCEEDINGS, vol. 2/3, 25th August 1987, Seoul, Korea, pages 408- 412; L. HUI et al.: "Predictive classified vector quantization for image coding"
- 2EEE/IEICE GLOBAL TELECOM. CONFERENCE, 1987, vol. 1/3, 15th November 1987, Tokyo, Japan, pages 36-39; S. OKUBO et al.: "Progress of CCITT standardization on n*384 kbits/s video codec"
- GLOBECOM '85 CONFERENCE RECORD, vol. 1/3, 2nd November 1985, New Orleans, US, pages 1251-1255; L. CHIARIGLIONE et al.: "Multimedia communication at the basic ISDN access"
- IEEE JOURNAL ON SELECTED AREAS IN COMMUNICATIONS, vol. SAC-4, no. 8, November 1986, New York, US, pages 1202-120; H. YAMAGUCHI et al.: "A 64 kbot/s integrated visual communication system - New communication medium for the ISDN"
- E. Hölzler, H. Holzwarth, "Pulstechnik", Volume 2, Springer Verlag 1976, page 307

## Description

### Field of the Invention

The present invention relates to a multimedia data transmission system for transmitting data between a sending side and a receiving side.

### Prior Art

In the publication "IEEE/IEICE Global Telecommunications Conference", 1987, vol. 1/3, 15 November 1987, pages 36-39, defining the closest prior art from which the invention proceeds, it is disclosed a frame structure for a 384 kbit/s codec. This codec consists of 8 kbit/s sub-channels, collectively entitled "service channel". This 64 kbit/s service channel is used for making alignments on 100 Hz framing and 16.5 Hz multiframing. The remaining 320 kbit/s are dedicated for video signals. One main problem of such a transmission system is due to the fact that the transmission capacity cannot be used effectively. There are no means for setting individual frame formats corresponding to each transmission rate. The conventional transmission system has a frame repetition of 100 Hz and a transmission rate of 384 kbps. Thus, the length of one frame is 3840 bit uniformly.

Since this transmission frame structure is based on a bit rate assignment for each sub-channel, it is apparent that this frame structure cannot be directly applied e.g. to the 56 kbps line which is generally employed in the USA, or to the 32 kbps line which is often used for the communication networks in private companies.

Fig. 1 shows a frame structure of a further multimedia data transmission system of the prior art indicated in the Technical Report ICS87-7 of IECE Japan, 1987, by Juji Matsumoto, entitled "Structure and Application of Interface in 64 Kbps System Multimedia Communication System". In the same figure, 716 designates octet frame comprised of eight subchannels of 1 bit having the repetition frequency of 8 kHz; 717 designates transmission frame comprised of 80 octet frames 716.

Fig. 2 is a table for explaining assignment of frame synchronous signal (FAS) in Fig. 1.

Fig. 3 is a table embodying content of frame synchronous signal (FAS) in the multiframe formed by 16 transmission frames 717 in Fig. 2.

Fig. 4 a profile for sending the transmission frame shown in Fig. 2 to the transmission path with the bit rate of 64 Kbps. In this figure, 718 designates a bit string to be sent to the 64 Kbps transmission path.

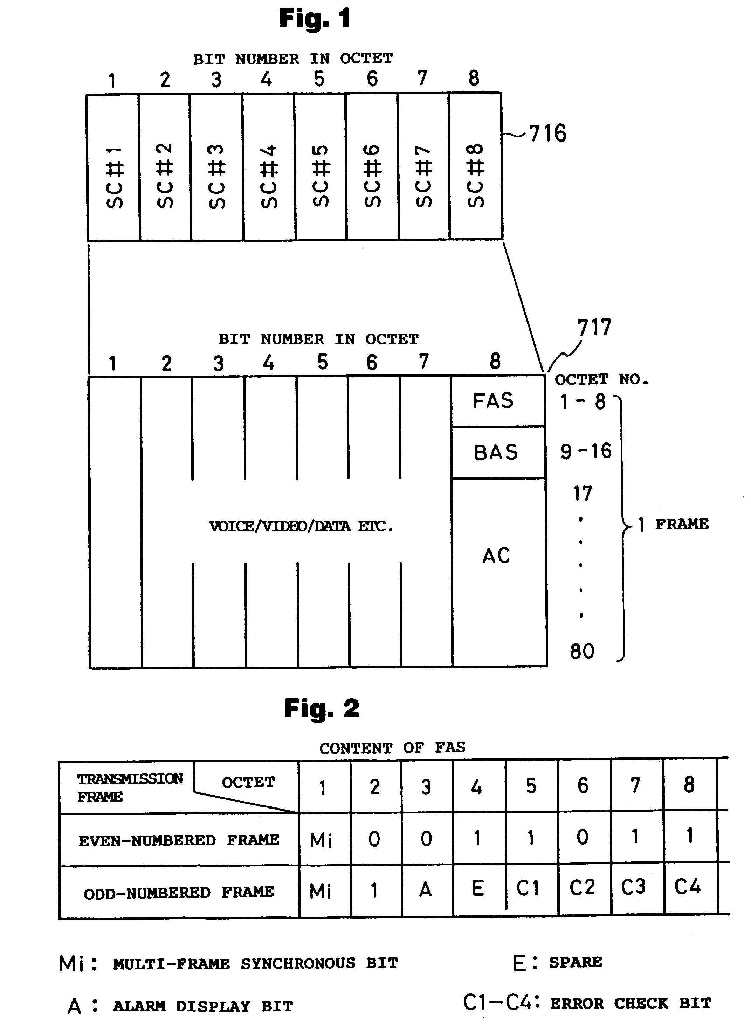

Operation will then be explained. In Fig. 2, the octet frame 716 has the 8-bit length. The frequency T_{oct} of the octet frame 716 in case it is sent to the line with transmission rate of 64 Kbps is given by${\text{T}}_{\text{oct}} \text{= 64 Kbps/8-bit = 8 kHz}$ and transmission capacity Cₛ per subchannel of 1 bit is indicated by${\text{C}}_{\text{s}} {\text{= 1 bit × T}}_{\text{oct}} \text{= 8 Kbps}$

Namely, in case the subchannel in the octet frame 716 is individually assigned to the voice, video signal and data, each assigning rate becomes an integer time of 8 Kbps. It provides an advantage that matching with voice encoding and decoding apparatus (voice codec)usually having the sampling frequency of 8 kHz can be obtained easily. The transmission frame 717 is formed by 80 octet frames 716 with the frame bits occupying the 8th subchannel (service channel) in the octet frame 716 for identifying the subchannel in the octet frame 716 and also identifying assignment of subchannel to each media. The 8th subchannel (service channel) in the transmission frame 716 makes a cycle in use in the 80 octet frames 716.

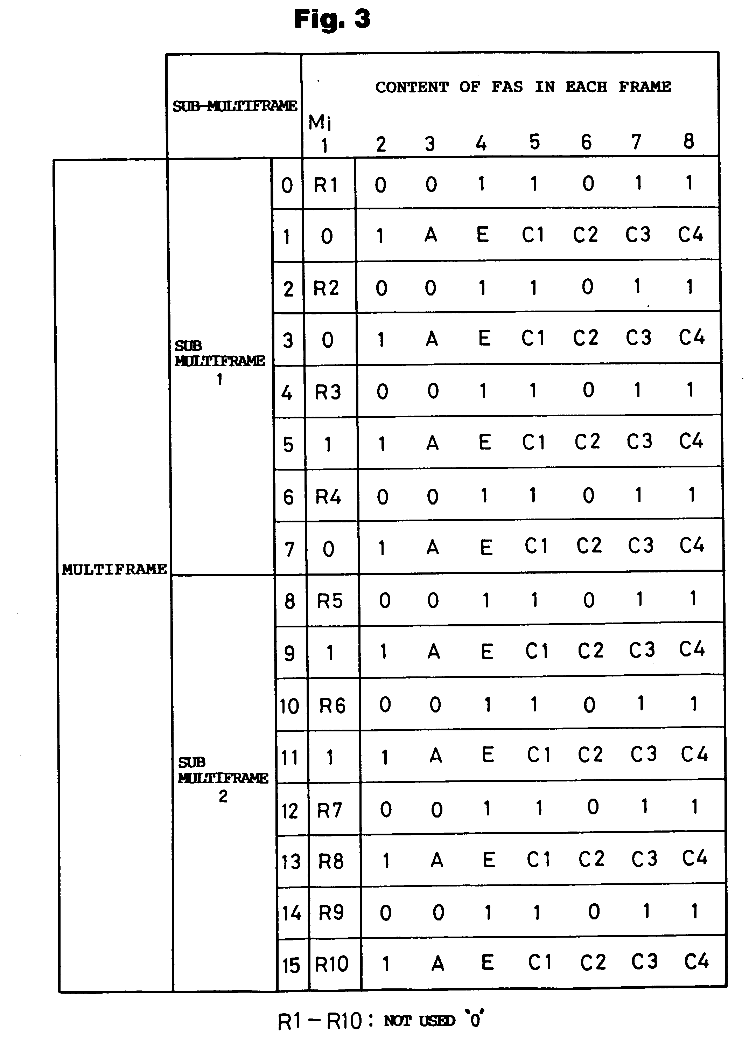

The 8th subchannel (service channel) is formed by 8-bit frame synchronous signal FAS, 8-bit bit rate assigning signal BAS and 64-bit application channel AC. A content shown in Fig. 2 is arranged as the frame synchronous pattern in the FAS to decide the frame synchronization and the multiframe synchronization formed by collecting 16 transmission frames 717. In the receiving side, the synchronization of transmission frame 717 is first set by detecting unique pattern. Next, the multiframe synchronization is set on the basis of the Mi bit shown in Fig. 2. Fig. 3 is a table indicating content of the Mi bit indicated in Fig. 2 and the unique pattern and additional information are arranged by assigning 16 bits to the Mi bit in the one multiframe.

BAS in the transmission frame 717 is dynamically changing the assigning information for each of 8 transmission frames SMF1, FMS2 717 which is equal to 1/2 of the multiframe shown in Fig. 3 and the same BAS information is transmitted 8 times in total, with each transmission directed to the transmission frame 717 of SMF1 and SMF2. In the receiving side, an error protecting means for identifying bit rate assignment in the next SMF based on the BAS information which is matched in content for 5 times or more among 8 times in total is applied.

The application channel AC is assigned to a command data for inter-terminal negotiation during the initial setting but it is assigned to user data during communication for effective use of lines. The bit capacity CA_{c} of AC is given according to the following relation.${\text{CA}}_{\text{c}} {\text{= T}}_{\text{oct}} \text{× 64/80 = 64 Kbps}$

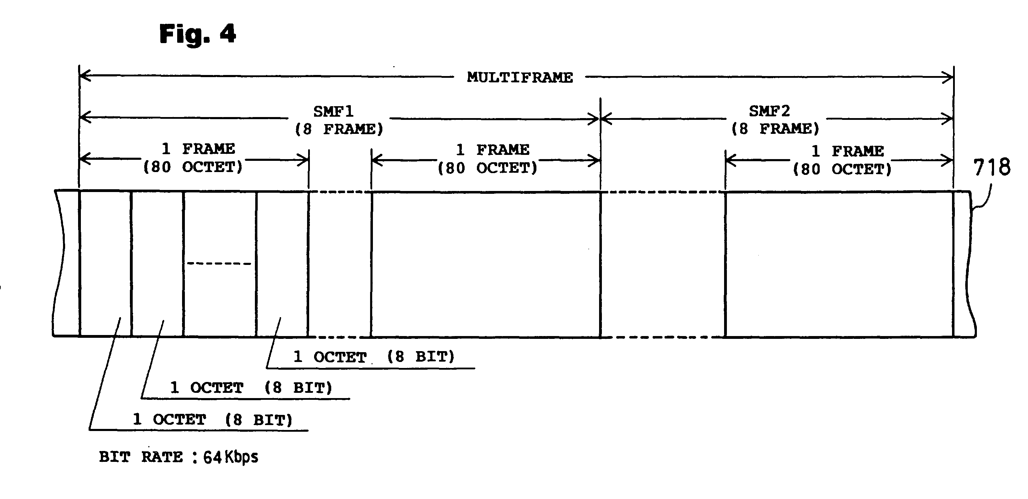

Fig. 4 shows practical structure of the transmission frame 717 to be transmitted to the 64 Kbps line in accordance with the above description.

The transmission frame structure is based on the bit rate assignment for each subchannel having the capacity of 8 Kbps and it is apparent that this frame structure cannot directly be applied to the 56 Kbps line which is generally employed in the US or to the 32 Kbps line which is often used for the communication networks in the private companies.

Since the multimedia data transmission system of the prior art has been constituted as described above, it is difficult to apply this system to the line of ℓ × 8 Kbps (ℓ is an integer of 1 or larger). For instance, there is a problem that amount of H/W increases and transmission capacity cannot be used effectively for the necessity of setting individual frame formats corresponding to each transmission rate in order to provide the function suitable for the ℓ × 8 Kbps line with the same apparatus.

In "ICASSP '87 A Proceedings", vol. 2/4, 6 April 1987, pages 1059-1062, it is disclosed an adaptive vector-quantization scheme with a codebook replenishment for color image-sequence compression. This scheme uses mean/residual vector quantization with binary-tree search algorithm to vector-quantize a Y component and a low-passed I and Q components of color images. It also incorporates an objective criteria for codebook replenishment. The mean and label replenishment technique is also applied to further reduce the bit-rate.

In E. Hölzler, H. Holzwarth, "Pulstechnik", vol. II, Springer-Verlag 1976, page 307, it is described the pulse stuffing method used for dummy bit insertion.

### Summary of the Invention

It is an object of the present invention to provide frame formats for various transmission rates.

In order to achieve this object, according to the invention, there is provided a multimedia data transmission system for transmitting data between a sending side and a receive side comprising means for configurating transmission frames of 80 x ℓ-bit lengths having the repetition frequency of 100 Hz, the transmission frames uniformly collecting 80 basic time slots, specified without relation to the transmission rate, of ℓ-bit lengths having the repetition frequency of 8 kHz corresponding to the transmission rate of 8 x ℓ kbps, means for configurating a multiframe by uniformly collecting 16 transmission frames without relation to the transmission rate, means for multiplexing a multimedia data, in every said basic time slot, transmission frame or multiframe having a code transmission rate which is an integer multiple of 8 kbps or matching said transmission frames or multiframe, and communication control means for notifying the receiving side by arranging and transmitting a synchronous code for identifying the boundaries of transmission frames and multiframes and bit allocation information indicating the bit assignment of multimedia data to a predetermined bit in said basic time slot.

The transmission system according to the present invention therefore can be used for setting individual frame formats corresponding to each transmission rate, e.g. may be adapted to the ℓ x 8 kbps line. So, the transmission system can be applied with the same transmission frame format on the basis of the frame of one bit length having the repetition frequency of 8 kHz in the ℓ x 8 kbps. Thereby, the invention provides a small size and economical apparatus, enhancing a degree of flexibility of lines and resulting in the effect that the digital network can be used economically.

Further advantages and embodiments of the invention are defined in the subclaims.

### Brief Description of the Drawings

- Fig. 1: is a frame format of a multimedia data transmission system of the prior art;
- Fig. 2: is an illustration for indicating the content of FAS in the multimedia data transmission system of the prior art;
- Fig. 3: is a multiframe format of the multimedia data transmission system of the prior art;
- Fig. 4: is an illustration for explaining a profile of transmission of a bit string to the transmission line in the multimedia data transmission system of the prior art;

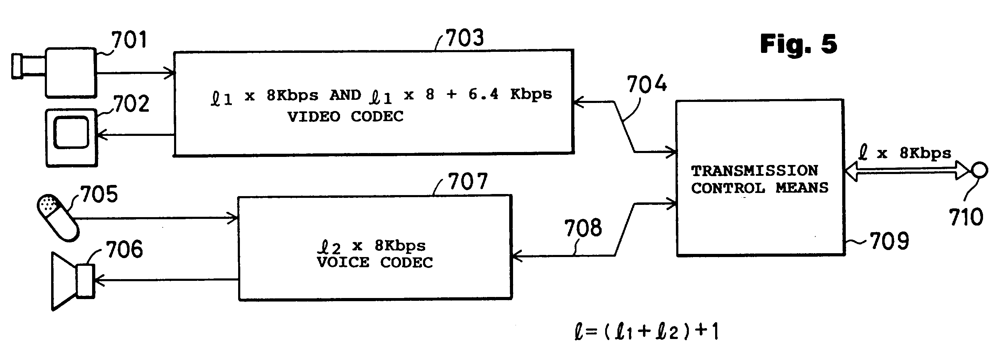

- Fig. 5: is a structure of a video communication terminal having a multimedia data transmission system according to a preferred embodiment of the present invention;

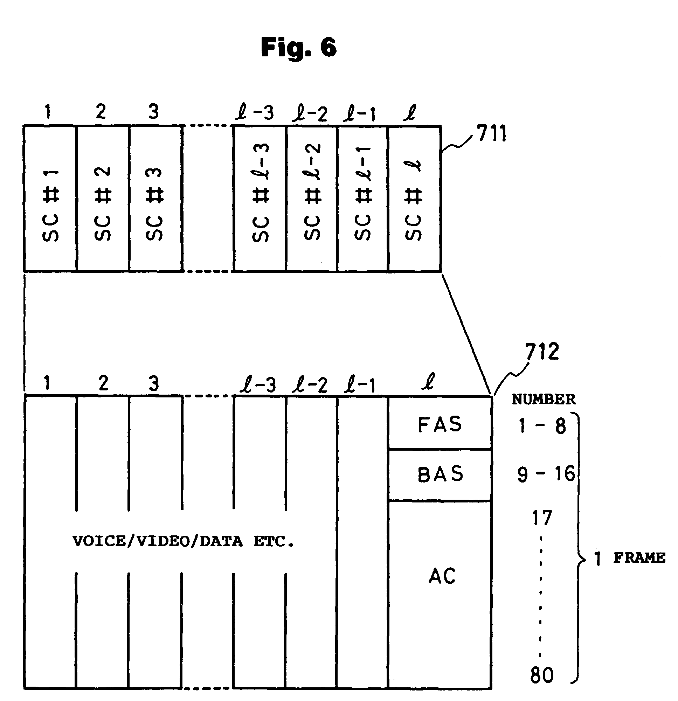

- Fig. 6: is a frame format of the multimedia data transmission system according to that preferred embodiment of the present invention;

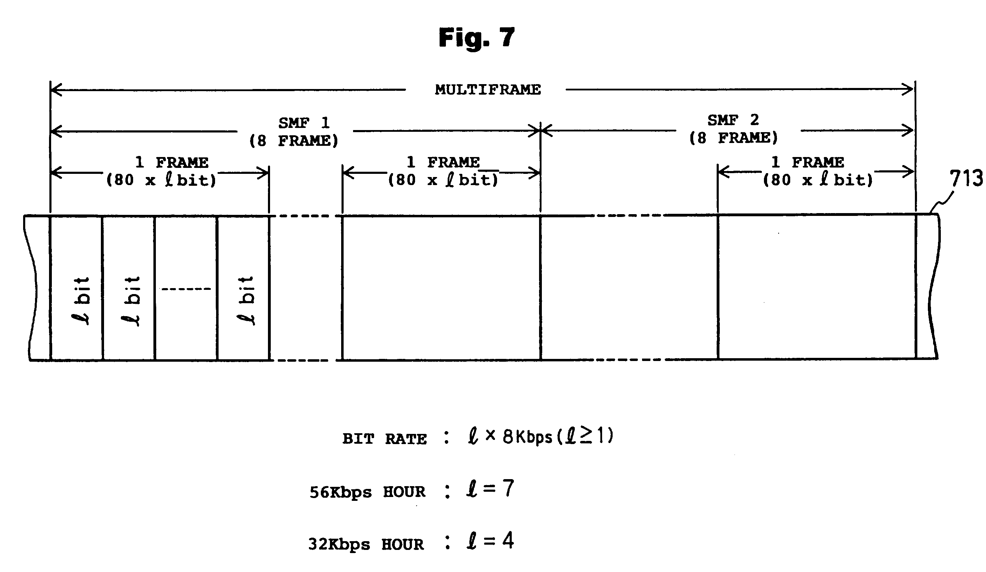

- Fig. 7: is an illustration for explaining the sending of a bit string to the transmission line by the multimedia data transmission system in the preferred embodiment of the present invention; and

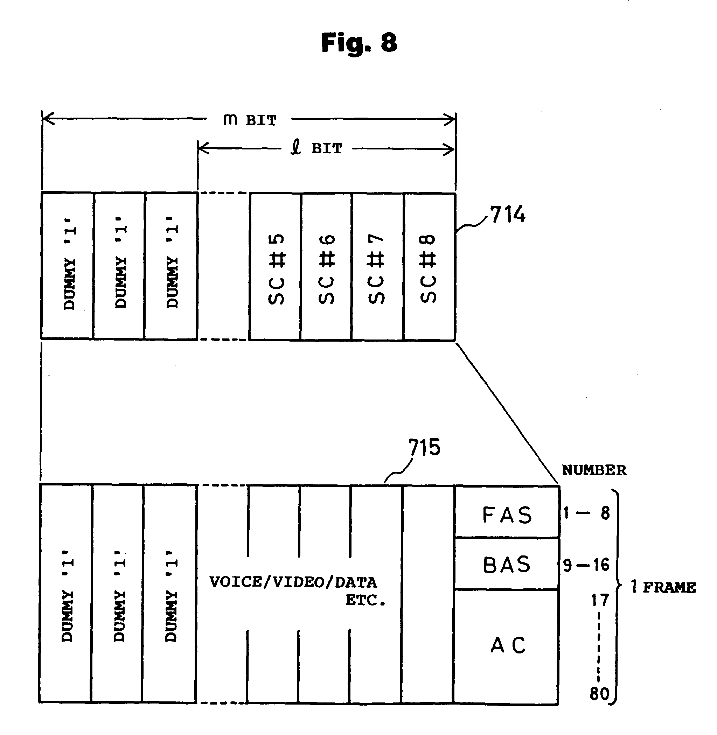

- Fig. 8: is a frame format of the multimedia data transmission system according to a further embodiment of the present invention.

### Preferred Embodiment of the Invention

A preferred embodiment of this invention will be explained with reference to Figs. 5 - 8. Referring to Fig. 5, 701 denotes a camera; 702, monitor; 703, high performance dynamic video encoding apparatus (video codec) of ℓ₁ × 8 Kbps to (ℓ₁ × 8 + 6.4) Kbps coding rate connected to the camera 701 and monitor 703; 704, digital data output of video codec 703; 705, microphone; 706, speaker; 707, high performance voice encoding apparatus (voice codec) of ℓ₂ × 8 Kbps coding rate; 708, digital data output of voice codec 707; 709, transmission control means for multiplexing digital data 704 and 708 to ℓ × 8 Kbps to transmit to the transmission line 710; 710, digital transmission line having the capacity of ℓ × 8 Kbps connected to the transmission control means.

Fig. 6 illustrates a data transmission frame format for the transmission control means 710 of Fig. 5. In the same figure, 711 denotes basic time slot of 1-bit length having the repetition frequency of 8 kHz; 712, transmission frame comprised of 80 basic time slots 711.

Fig. 7 illustrates a profile of trransmission frame to be sent to the ℓ × 8 Kbps line from the transmission control means 710 shown in Fig. 5. In the same figure, 713 is bit string data transmitted to the transmission line.

Operation will then be explained hereunder. Fig. 5 shows an example of applying the present invention to a video communication terminal having the multiplex communication function with ℓ₁ × 8 Kbps to (ℓ₁ × 8 + 6.4) Kbps video signal and ℓ₂ × 8 Kbps voice signal. ℓ₁, ℓ₂ are integers equal to or larger than 1 and channel is assigned to the video and voice signals under the relationship of ℓ = ℓ₁ + ℓ₂ + 1. Here, the video signal input from the camera 701 is encoded in the video codec 702, from which the digital data 704 of ℓ₁ × 8 Kbps to (ℓ₁ × 8 + 6.4) Kbps is transmitted. Meanwhile, the voice codec 707 encodes the voice signal input from the microphone 705 and transmits the digital data 708 of ℓ₂ × 8 Kbps. The transmission control means 709 multiplexes the digital data 704 and 708 into ℓ × 8 Kbps (ℓ is integer equal to or larger than 1) to send to the transmission line 710. In the receiving side, operations are conducted in the reverse manner to decode the digital data 704 and 708 in order to output the regenerated video and voice signals from the monitor 701 and speaker 706.

In Fig. 6, the transmission frame format in the transmission control means 709 is explained. Since the basic time slot 711 has the 1-bit length, the repetition frequency Tₛ of basic time slot becomes as follow under the transmission rate of ℓ × 8 Kbps.${\text{T}}_{\text{s}} \text{= ℓ × 8 Kbps/ℓ bit = 8 Hz}$

Therefore, the transmission capacity of each subchannel is given as 8 Kbps and the transmission frame 712 can be formed on the basis of the basic time slot of 8 kHz as in the case of prior art. Accordingly, in case the frame format same as the prior art, for example, is applied in the present invention, the transmission frame 712 can be applied to the line of ℓ × 8 Kbps even when it is the same. In this case, the first subchannel is used as the service channel and structure of FAS, BAS, AC does not depend on the value of ℓ. Therefore, any problem does not occur even when the structure of FAS, BAS, AC is the same as that shown in Fig. 2 and Fig. 3 and it makes possible to apply such structure to the ℓ × 8 Kbps line under the same H/W.

Thereby, in case the ℓ₁ bits in the bits are assigned to the video signal in Fig. 5, the bit rate of ℓ₁ × 8 Kbps can be assigned and moreover when the AC is assigned to the video signal, the bit rate of (ℓ₁ × 8 + 6.4) Kbps can be assigned. In addition, assignment of ℓ₂ bits to the voice signal makes possible the assignment of the bit rate of ℓ₂ × 8 Kbps to the voice signal and this bit rate matches the encoding rate of voice codec as is described previously.

Fig. 7 illustrates a profile of a bit string 712. The multiframe format and frame format are same as those of prior art. When the line rate is 56 Kbps, such bit rate can be attained by selecting ℓ = 7, and when the rate is 32 Kbps, it can be attained by selecting ℓ = 4.

In above explanation about this embodiment, the bit rate of transmission line 710 is set to ℓ × 8 Kbps, but the interface rate to the line may be selected to m × 8 Kbps (m is integer ≧ ℓ). In this case, it is enough that the dummy data of m-l bits is properly arranged in the frame 714. In this case, the dummy data and the data from the other transmission line may be ORed and can also be multiplexed by setting the content of dummy data to "1".

Fig. 8 is a frame format under this condition, wherein the frame of ℓ-bit is arranged in the basic frame of m-bit to form the transmission frame 715.

## Claims

1. A multimedia data transmission system for transmitting data between a sending side and a receiving side comprising:
means for configurating transmission frames of 80 × ℓ-bit lengths having the repetition frequency of 100 Hz, the transmission frames uniformly collecting 80 basic time slots, specified without relation to the transmission rate, of ℓ-bit lengths having the repetition frequency of 8 kHz corresponding to the transmission rate of 8 × ℓ kbps;
means for configurating a multiframe by uniformly collecting 16 transmission frames without relation to the transmission rate;
means for multiplexing a multimedia data, in every said basic time slot, transmission frame or multiframe having a code transmission rate which is an integer multiple of 8 kbps or matching said transmission frames or multiframe; and
communication control means for notifying the receiving side by arranging and transmitting a synchronous code for identifying the boundaries of transmission frames and multiframes and bit allocation information indicating the bit assignment of multimedia data to a predetermined bit in said basic time slot.

2. A multimedia data transmission system according to claim 1, including
means for setting the number of basic time slots in the transmission frame and the number of transmission frames in the multiframe to constant values independent of the transmission rates of 8 × ℓ kbps and for setting the additional information including synchronous code and bit assigning information to a common value corresponding all transmission rates with the same control means.

3. A multimedia data transmission system according to claim 1,
wherein a bit rate for interface is fixed to 64 kbps in the transmission path having the transmission rate of 8 × ℓ kbps and the same transmission path interface is used, not depending on the transmission rate of 32/48/56 kbps, including means for converting the transmission rate to the interface bit rate through matching of transmission rate by adding dummy bit of (8-ℓ)-bit lengths to 8 × ℓ kbps for each basic time slots and a means for extracting only the valid bits by eliminating dummy bits with a timing signal of 8 kHz synchronizing with the partition of basic time slot obtained from periodicity of dummy bit in the receiving side or the basic time slot supplied from the interface.

## Patentansprüche

1. Übertragungssystem für Multimediadaten zum Übertragen von Daten zwischen einer Sendestation und einer Empfangsstation, mit:
einer Einrichtung zum Konfigurieren von Übertragungsrahmen von 80 × ℓ Bits Länge mit der Wiederholungsfrequenz von 100 Hz, wobei die Übertragungsrahmen einheitlich 80 Basiszeitschlitze zusammenfassen, die ohne Relation zu der Übertragungsgeschwindigkeit festgelegt sind, mit einer Länge von *ℓ* Bits mit der Wiederholungsfrequenz von 8 kHz entsprechend der Übertragungsgeschwindigkeit festgelegt sind von 8 × ℓ kbps;
einer Einrichtung zum Konfigurieren eines Mehrfachrahmens durch einheitliches Zusammenfassen von 16 Übertragungsrahmen ohne Relation zur Übertragungsgeschwindigkeit;
einer Einrichtung zum Multiplexen von Multimediadaten in jedem der Basiszeitschlitze, wobei der Übertragungsrahmen oder Mehrfachrahmen eine Codeübertragungsgeschwindigkeit aufweist, welche ein ganzzahliges Vielfaches von 8 kbps ist oder mit den Übertragungsrahmen oder Mehrfachrahmen übereinstimmt; und
einer Kommunikationssteuerungseinrichtung zum Benachrichtigen der Empfangsstation durch Anordnen und Übertragen eines synchronen Codes zum Identifizieren der Grenzen der Übertragungsrahmen und Mehrfachrahmen und einer Bit-Zuordnungsinformation, welche die Bit-Zuordnung von Multimediadaten zu einem vorbestimmten Bit in dem Basiszeitschlitz anzeigt.

2. Übertragungssystem für Multimediadaten nach Anspruch 1, mit einer Einrichtung zum Einstellen der Anzahl der Basiszeitschlitze in dem Übertragungsrahmen und der Anzahl der Übertragungsrahmen in dem Mehrfachrahmen auf konstante Werte, unabhängig von der Übertragungsgeschwindigkeit von 8 × *ℓ* kbps, und zum Einstellen der zusätzlichen Informationen einschließlich Synchroncode und Bit-Zuordnungsinformation zu einem gemeinsamen Wert entsprechend aller Übertragungsgeschwindigkeiten in derselben Steuerungseinrichtung.

3. Übertragungssystem für Multimediadaten nach Anspruch 1, bei welchem eine Bitgeschwindigkeit für eine Schnittstelle auf 64 kbps in dem Übertragungsweg mit der Übertragungsgeschwindigkeit von 8 × ℓ kbps festgelegt ist und dieselbe Übertragungswegschnittstelle verwendet wird, und zwar unabhängig von der Übertragungsgeschwindigkeit von 32/48/56 kbps, mit einer Einrichtung zum Konvertieren der Übertragungsgeschwindigkeit in die Schnittstellen-Bitgeschwindigkeit durch Übereinstimmen der Übertragungsgeschwindigkeit durch Hinzufügen von Dummy-Bits von (8-ℓ)Bit Länge zu 8 × *ℓ* kbps für jeden Basiszeitschlitz und einer Einrichtung zum Extrahieren der gültigen Bits durch Beseitigen der Dummy-Bits mit einem Zeitsteuersignal von 8 kHz, das mit der Partition des Basiszeitschlitzes synchronisiert ist, welche von der Periodizität des Dummy-Bits an der Empfangsstation oder dem von der Schnittstelle abgegebenen Basiszeitschlitz erhalten wird.

## Revendications

1. Système de transmission de données multimédia destiné à transmettre des données entre un côté émetteur et un côté récepteur comprenant :
des moyens destinés à configurer des trames de transmission d'une longueur de 80 x ℓ-bit ayant une fréquence de répétition de 100 Hz, les trames de transmission réunissant uniformément 80 intervalles de temps de base, ayant pour caractéristique de ne pas avoir de relation avec le débit de transmission, d'une longueur de ℓ-bit ayant une fréquence de répétition de 8 kHz correspondant au débit de transmission de 8 x ℓ Kbits/s ; des moyens de configuration d'une multitrame par la réunion uniforme de 16 trames de transmission sans relation avec le débit de transmission ; des moyens de multiplexage de données multimédia, dans chaque dit intervalle de temps de base, la trame ou la multitrame de transmission ayant un débit de transmission de code qui est un nombre entier multiple de 8 Kbits/s ou d'adaptation desdites trames ou multitrame de transmission ; et
des moyens de contrôle de la communication destinés à la notification du côté récepteur en disposant et en transmettant un code synchrone destiné à identifier les limites des trames et des multitrames de transmission et une information d'attribution de bit indiquant l'affectation de bit des données multimédia à un bit prédéterminé dans ledit intervalle de temps de base.

2. Système de transmission de données multimédia selon la revendication 1, comprenant
des moyens destinés à établir le nombre d'intervalles de temps de base dans la trame de transmission et le nombre de trames de transmission dans la multitrame à des valeurs constantes indépendantes des débits de transmission de 8 x ℓ Kbits/s et à établir les informations supplémentaires comprenant le code synchrone et les informations d'affectation de bit à une valeur commune correspondant à tous les débits de transmission avec les mêmes moyens de contrôle.

3. Système de transmission de données multimédia selon la revendication 1, dans lequel un débit binaire pour interface est fixé à 64 Kbits/s dans la voie de transmission ayant le débit de transmission de 8 x ℓ Kbits/s et dans lequel la même interface de voie de transmission est utilisée, ne dépendant pas du débit de transmission de 32/48/56 Kbits/s, comprenant des moyens destinés à convertir le débit de transmission au débit binaire d'interface en adaptant le débit de transmission par l'addition d'un bit virtuel d'une longueur de (8-ℓ)-bit à 8 x ℓ Kbits/s pour chaque intervalle de temps de base et un moyen destiné à extraire seulement les bits valables en éliminant les bits virtuels avec un signal de synchronisation de 8 kHz par synchronisation avec la division de l'intervalle de temps de base obtenu à partir de la périodicité de bit virtuel du côté récepteur ou de l'intervalle de temps de base fourni depuis l'interface.
